Europäisches Patentamt

European Patent Office

Office européen des brevets

(11) Veröffentlichungsnummer: **0 269 608**
**A2**

(19)

(12) **EUROPÄISCHE PATENTANMELDUNG**

(21) Anmeldenummer: 87890251.9

(22) Anmeldetag: 11.11.87

(51) Int. Cl.⁴: **H 05 K 7/14**

(30) Priorität: 20.11.86 AT 3105/86

(43) Veröffentlichungstag der Anmeldung:
01.06.88 Patentblatt 88/22

(84) Benannte Vertragsstaaten:
AT BE CH DE ES FR GB GR IT LI LU NL SE

(71) Anmelder: Alcatel Austria Aktiengesellschaft
Scheydgasse 41
A-1210 Wien (AT)

(72) Erfinder: Nemeth, Herbert
Gerasdorferstrasse 61/45/10
A-1210 Wien (AT)

(54) Vorrichtung zum Einschieben bzw. Ausziehen von mit Steckerleisten versehenen Karten oder anderen Einschüben.

(57) Eine Vorrichtung zum Einschieben und Ausziehen von elektrische Bauelemente tragenden Karten (4) weist apparatefeste Längsträger (3) auf, auf denen die Karten verschiebbar geführt sind. Für den elektrischen Anschluß der Karten sind Steckerleisten (7) und Steckergegenleisten vorgesehen. Im Bereich der äußeren Ecken der Karte (4) sind Betätigungshebel (11) an einer mit der äußeren Stirnkante (14) der Karte verbundenen Griffleiste (15) angelenkt, die im Bereich der Zusammenwirkung von Steckerleiste und Steckergegenleiste mit einem Rastarm (12) mit apparatefesten Rasten (13) zusammenwirken und im bewegbaren, ausgezogenen Zustand der Karte (4) im wesentlichen innerhalb der seitlichen Kartenkanten liegen. Damit ist trotz einfacher und sicherer Ermöglichung des Einschiebens bzw. Ausziehens der Karte (4) außerhalb des für das Einschieben bzw. Ausziehen selbst erforderlichen Platzes genügend Raum für die Unterbringung beispielsweise von Kabelkanälen (18) od.dgl.gegeben, was eine kompakte Konstruktion ermöglicht, Gleichzeitig ist durch die Verwendung von leitfähigen Materialien die Elektronik vor statischen Entladungen geschützt.

FIG.1

## Beschreibung

Die Erfindung bezieht sich auf eine Vorrichtung zum Einschieben bzw. Ausziehen von mit Steckerleisten versehenen Karten oder anderen Einschüben mit elektrischen bzw. elektronischen Bauteilen in bzw. aus die Steckerleisten aufnehmenden apparatefesten Steckergegenleisten, wobei die Karten in Einschiebe- bzw. Ausziehrichtung in Längsträgern, wlche zusammen mit sie tragenden Querträgern apparatefest sind, geführt sind, und wobei im Bereich der äußeren Ecken der Karten in einer Kartenebene drehbare, zweiarmige Betätigungshebel an den Karten angelenkt sind, die im Bereich der Zusammenwirkung von Steckerleisten und Steckergegenleisten mit einem Rastarm mit apparatefesten Rasten zusammenwirken.

Vorrichtungen dieser Art sind in verschiedenen Ausführungen bekannt und dienen im wesentlichen dazu, die zum Öffnen der Kontaktfedern und zur Überwindung der Reibungskräfte an den Kontakten der Steckerleiste und der Steckergegenleiste erforderliche Kraft sicher und ohne Gefahr einer Beschädigung der Karte aufbringen zu können. Dies ist insbesondere im Hinblick auf den immer weitergehenden Trend zur Miniaturisierung und den damit gegebenen ständig steigenden Kontaktzahlen je Karte bedeutsam, da die dadurch zum Einschieben bzw. Ausziehen der Karte erforderliche Kraft bereits so groß wird, daß bei nicht präzise ausgeführtem Bewegungsvorgang Deformationen und Zerstörungen an der Karte und an den Steckerteilen auftreten können.

Aus der DE-OS 33 22 856 ist eine Vorrichtung der eingangs genannten Art bekannt, bei der die Betätigungshebel als Winkelhebel ausgeführt sind und an ihrem Rastarm jeweils in die Stirnseiten von horizontal angeordneten Tragschienen eingreifen. Abgesehen davon, daß die Ausbildung und Anordnung dieser Winkelhebel sowie insbesondere auch der zur Verriegelung der Karte zusätzlich vorgesehenen Elemente kompliziert ist, hat diese bekannte Anordnung den wesentlichen Nachteil, daß der Bereich, wo die Winkelhebel mit den horizontalen Tragschienen zusammenwirken, bei moderner kompakter Bauweise mit Frontverkabelung für Kabelkanäle benötigt wird und damit für den Eingriff der Winkelhebel nicht mehr zur Verfügung steht.

Ähnliche Probleme ergeben sich auch im Zusammenhang mit der aus der DD-PS 214 278 bekannten Anordnung, bei der sich die Betätigungshebel auf den Stirnflächen bzw. an Ansätzen von Bolzen abstützen, die sich über und unter den Leiterplatten befinden. Da diese Bereiche - wie oben bereits erwähnt - bei modernen, kompakten Bauweisen für Kabelkanäle benötigt werden, ist auch diese bekannte Lösung für derartige Anordnungen nicht mehr anwendbar.

Aufgabe der Erfindung ist es, eine Vorrichtung der eingangs genannten Art so zu verbessern, daß die Nachteile der bekannten Vorrichtungen vermieden werden und daß insbesondere mit einfachen Mitteln erreicht wird, daß ohne in Anspruchnahme des bei modernen, kompakten Konstruktionen für Kabelkanäle u.dgl. erforderlichen Platzes im Bereich der oberen und unteren Außenecken der Karte ein sicheres Einschieben und Ausziehen ermöglicht wird.

Mit der Erfindung wird dies dadurch erreicht, daß die Betätigungshebel an einer mit der äußeren Stirnkante der Karte verbundenen Griffleiste angelenkt sind und im bewegbaren, ausgezogenen Zustand der Karte im wesentlichen inerhalb der seitlichen Kartenkanten liegen. Diese Griffleiste trägt damit die Betätigungshebel samt ihrer Anlenkung, so daß einerseits auf der Karte selbst keine zusätzlichen Maßnahmen für die Anlenkung der Betätigungshebel zu treffen sind und anderseits eine einfache Herstellung, Montage und Wartung gesichert ist. Da die Betätigungshebel im bewegbaren Zustand der Karte, also wenn die Kontakte zwischen den Steckerleisten und den Steckergegenleisten noch nicht oder nicht mehr geschlossen sind, innerhalb der seitlichen Kartenkanten liegen, ist der außerhalb der seitlichen Kartenkanten beim Herausziehen der Karte nicht ohnedies für deren Bewegung erforderlich Platz auch nach wie vor für die Anbringung von Kabelkanälen od.dgl. frei und ermöglicht damit eine kompakte Ausführung des gesamten Apparates. In weiterer Ausgestaltung der Erfindung ist vorgesehen, daß die Griffleiste in ihrem Mittelbereich eine Handhabe aufweist, an welcher die Handgriffe der Betätigungshebel im eingeschobenen Zustand anliegen. Diese Handhabe ermöglicht eine sichere Handhabung der Karte unabhängig von den beweglichen Betätigungshebeln, wobei im vollständig eingeschobenen Zustand der Karte, bzw. auch bei einer vom Apparat entfernten Lagerung der Karte, ein geschlossenes Bild der Griffleiste unter weitgehender Ausschließung einer irrtümlichen Betätigung erzielt wird.

Die Betätigungshebel können nach einer bevorzugten weiteren Ausbildung der Erfindung über federnd ausgebildete Endhalterungen in einer Bewegungs- und Verriegelungsendstellung gehalten sein, wobei die zusammenwirkenden Teile dieser Endhalterungen am Betätigungshebel einerseits und an der Griffleiste anderseits angebracht sind. In der zum Einschieben und Ausziehen der Karte von den Betätigungshebeln eingenommenen Bewegungsendstellung sind also die Betätigungshebel federnd in ihrer Drehstellung gegenüber der Karte fixiert, so daß die Karte allein über die Handhabe bewegt werden kann, ohne daß die Betätigungshebel von der Bedienungsperson beachtet oder gehalten werden müßten. Beim unmittelbaren Einschieben, also wenn die Kontakte zwischen Steckerleiste und Steckergegenleiste hergestellt werden, werden die Betätigungshebel in ihre Verriegelungsendstellung bewegt, wo sie wiederum gegenüber der Karte durch die Endhalterungen gesichert sind, so daß eine Transportsicherung und eine Vibrationssicherung im Betrieb gegeben ist.

Die Griffleiste kann nach einer anderen Ausgestaltung der Erfindung den für die Karte senkrecht zu ihrer Bewegungsrichtung zur Verfügung stehenden Platz im eingeschobenen Zustand der Karte im wesentlichen vollständig überdecken. Damit ist ein Berührungsschutz für die auf der Karte befindlichen elektrischen Baugruppen und Bauelemente von der Frontseite her gegeben und gegebenenfalls auch eine geschlossene Kühlluftführung im Inneren des die Karte aufnehmenden Gehäuses möglich.

Insbesondere im zuletzt angesprochenen Zusammenhang ist eine weitere Ausgestaltung der Erfindung von Vorteil, bei der die Griffleiste mit Fenstern oder Öffnungen versehen ist, durch die hindurch auf der Karte angeordnete Ffrontelemente, z.B. Stecker, Schalter und Anzeigen, betätigbar sind. Damit ist kein zusätzlicher Platzaufwand auf der Stirnseite der Karte erforderlich, um Frontverkabelungen od.dgl. zu ermöglichen. Die Fenster oder Öffnungen können in kleinen Plättchen vorgesehen sein, die in der jeweiligen Anforderung entsprechender Ausgestaltung in größere Öffnungen der Griffleiste wahlweise einsetzbar sind. Auf der Griffleiste können auch Kennzeichnungen der Karte, z.B. Bezeichnungsstreifen mit Kurzbezeichnungen, Strichcodes od.dgl. vorgesehen sein, sowie auch andere Hinweise oder etwa Warnungen vor elektrostatisch empfindlichen Bauteilen. Dadurch wird die Anordnung übersichtlich und leicht kontrollierbar.

Die Griffleiste und die Betätigungshebel können gemäß der Erfindung aus einem Material mit definierter Leitfähigkeit, z.B. aus leitfähigem Kunststoff bestehen, wobei die Betätigungshebel durch den Eingriff in die zugehörigen Rasten im eingeschobenen Zustand der Karte eine elektrische Verbindung mit den Querträgern schaffen. Bei dieser Ausbildung werden allenfalls auftretende Potentialdifferzen zwischen der Karte oder anderen Einschüben und z.B. der Bedienungsperson über die Griffleiste, den Betätigungshebel und den Querträger abgeleitet, ohne daß die Funktion der auf der Karte oder den Einschüben befindlichen Bauteile beeinflußt wird.

Wenn nach einem weiteren Merkmal der Erfindung die Griffleiste samt den Betätigungshebeln mit der Masseleitung der Karte über einen definierten Ableitwiderstand elektrisch verbunden ist, wird ein langsamer Potentialausgleich gegen das Erdpotential der Karten und damit ein wirksamer Schutz der Bauelemente gegen elektrostatische Aufladung während der Manipulation ermöglicht.

Zur elektrischen bzw. magnetischen Abschirmung kann die Griffleiste zufolge einer anderen vorteilhaften Ausgestaltung der Erfindung metallisch, z.B. mit Ni, beschichtet sein, was bei der Herstellung der Griffleiste einfach durchführbar ist und zusätzliche Abschirmmaßnahmen im Bereich der Frontseite der Karte überflüssig macht.

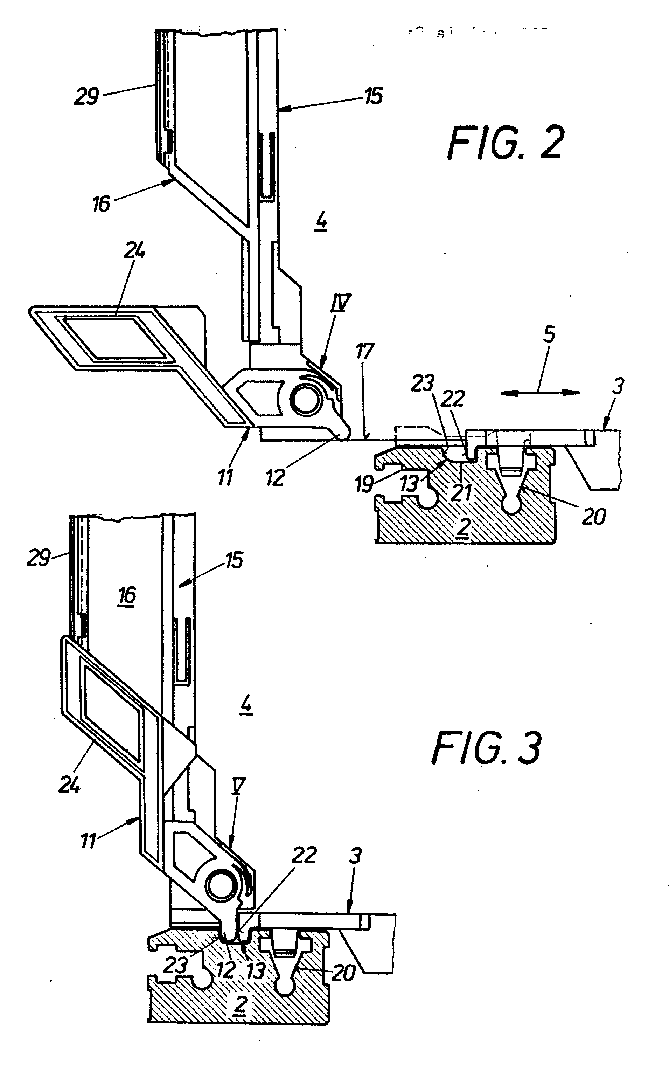

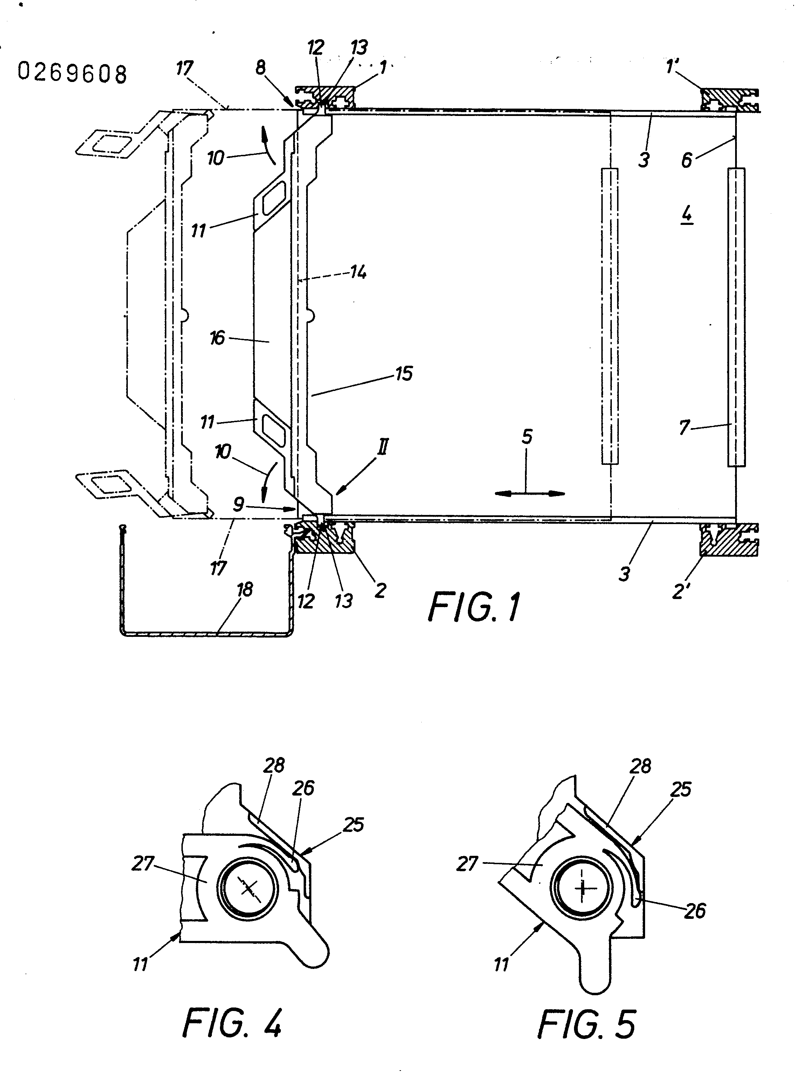

Die Erfindung wird im folgenden anhand des in der Zeichnung dargestellten Ausführungsbeispiels näher erläutert. Fig. 1 zeigt einen teilweise schematischen Ausschnitt aus einer Apparatur mit einer erfindungsgemäßen Vorrichtung zum Einschieben und Ausziehen einer Karte mit elektrischen Baugruppen, Fig. 2 zeigt das Detail 11 aus Fig. 1 in vergrößerter Darstellung, wobei der Kabelkanal angenommen und die Karte in ausgezogenem Zustand ist, Fig. 3 zeigt das gleiche Detail wie Fig. 2, wobei die Karte vollständig eingeschoben ist, und die Fig. 4 und 5 zeigen jeweils vergrößerte Darstellungen der Details IV and V aus den Fig. 2 bzw. 3.

Von dem in Fig. 1 nicht weiter dargestellten elektrischen bzw. elektronischen Apparat sind für die Zwecke der folgenden Erläuterung der Erfindung im wesentlichen nur die Querträger 1,1',2,2', sowie die von diesen getragenen Längsträger 3 wichtig, welche apparatefest sind. In den Längsträgern 3 ist eine Karte 4 mit nicht weiter dargestellten elektrischen Baugruppen in Richtung des Pfeils 5 geführt, welche an ihrer inneren Stirnseite 6 eine Steckerleiste 7 mit einer großen Anzahl von Kontaktstiften bzw. Kontaktfedern trägt, die in dem mit durchgezogener Linie dargestellten, komplett eingeschobenen Zustand der Karte 4 mit einer hier nicht dargestellten apparatefesten Steckergegenleiste bzw. deren Kontakten zusammenwirkt und damit die für den Betrieb der Anordnung erforderlichen elektrischen Anschlüsse zur Karte herstellt.

Zufolge der großen Anzahl von Kontakten an der Steckerleiste 7, die durch die heutzutage immer größeren Bauteildichten auf den einzelnen Karten erforderlich werden, sind beim Einstecken der Steckerleiste 7 in die zugehörige Steckergegenleiste relativ größe Kräfte zur Überwindung der Kontaktkräfte und der Reibungskräfte erforderlich, was natürlich auch für das Ausziehen der Karte gilt. Um diese Kräfte sicher und ohne Gefahr einer Beschädigung von Steckerleiste und Steckergegenleiste bzw. deren Kontakte aufbringen zu können, sind im Bereich der äußeren Ecken 8,9 der Karte 4 in der Kartenebene drehbare - siehe Pfeil 10 - zweiarmige Betätigungshebel 11 an der Karte 4 angelenkt, die im Bereich der Zusammenwirkung der Steckerleiste 7 mit der apparatefesten Steckergegenleiste, also beim unmittelbaren Zusammenwirken der entsprechenden Kontakte, mit einem Rastarm 12 mit apparatefesten Rasten 13 zusammenwirken.

Ebenfalls aus Fig. 1 zu ersehen ist noch eine mit der äußeren Stirnkante 14 der Karte 4 verbundene Griffleiste 15, die in ihrem Mittelbereich eine Handhabe 16 aufweist und an der - siehe insbesondere die Fig. 2 und 3 - die Betätigungshebel 11 angelenkt sind.

Im eingeschobenen Zustand der Karte 4 sind die Rastarme 12 der Betätigungshebel 11 im Eingriff mit den Rasten 13, welche hier an den Querträgern 1 bzw. 2 ausgebildet sind, wobei diese Verriegelungsendstellung der Betätigungshebel 11 über nachstehend zu den Fig. 2 und 2 besprochene Endhalterungen fixiert ist, was eine Transportsicherung bzw. Vibrationssicherung gegen eine Herausbewegung der Karte 4 ermöglicht. Zum Ausziehen der Karte 4 in die in Fig. 1 strickpunktiert angedeutete Stellung werden die Betätigungshebel 11 aus der Verriegelungsendstellung in eine Bewegungsendstellung verschwenkt, in der sie innerhalb der seitlichen Kartenkanten 17 liegen und mittels der oben bereits angesprochenen Endhalterungen gehalten sind. Auf diese Weise ist unbeanspruchter Raum im Bereich des vorderen, unteren Querträgers 2 geschaffen, der für einen Kabelkanal 18 genutzt werden kann, was sehr kompakte Bauweisen des gesamten Apparates ermöglicht.

In dem in Fig. 2 dargestellten Detail befindet sich die Karte 4 im ausgezogenen Zustand, wobei die hier nicht dargestellte Steckerleiste noch einen gewissen Abstand zur zugehörigen Steckergegenleiste hat, wodurch ein freies und relativ leichtes Gleiten der seitlichen Kartenkanten 17 in entsprechenden Nuten der Längsträger 3 möglich ist. Diese Bewegung ist wiederum durch den Pfeil 5 veranschaulicht. Ebenfalls in Fig. 2 zu erkennen ist die Querschnittsausbildung des profilierten Querträgers 2, welcher neben einer Längsnut 19 für die Aufnahme des hier nicht dargestellten Kabelkanals noch eine weitere Längsnut 20 für Aufnahme, Ausrichtung bzw. Halterung der Längsträger 3 sowie eine Nut 21 aufweist, welche zusammen mit einer Anschlagfläche 22 die Rast 13 für den Rastarm 12 des Betätigungshebels 11 bildet.

Wenn die Karte 4 aus der in Fig. 2 dargestellten ausgezogenen Stellung mittels der Handhabe 16 der Griffleiste 15 relativ zum Querträger 2 bzw. Längsträger 3 auf diesem nach rechts verschoben wird, kommt irgendwann die Steckerleiste an der inneren Stirnseite der Karte 4 zum Beginn ihrer Zusammenwirkung mit der apparatefesten Steckergegenleiste. In dieser Stellung wird sich der Rastarm 12 des Betätigungshebels 11 bereits oberhalb der einerseits durch die Fläche 23 der Nut 21 und anderseits durch die Anschlagfläche 22 begrenzten Raste 13 befinden. Sobald nun zufolge der zur Überwindung der Kontaktfederkräft und Reibungskräfte erforderlichen, jäh ansteigenden Kraft zur Weiterbewegung der Karte 4 die Bedienungsperson auf dieses Anliegen der Steckerleiste 7 an der zugehörigen Steckergegenleiste aufmerksam wird, kann über eine Schwenkung der Handgriffe 24 der Betätigungshebel 11 in Richtung zur Handhabe 16 die Karte 4 unter Ausnützung der Wirkung des zweiarmigen Hebels weiter in den Längsträgern 3 nach innen gezogen werden, womit sich die in Fig. 3 dargestellte Verriegelungsendstellung ergibt, bei welcher auf hier nicht dargestellte Weise der erforderliche Kontakt zwischen Steckerleiste und Steckergegenleiste sichergestellt ist.

Ausgehend von dem in Fig. 3 dargestellten, komplett eingeschobenen Zustand der Karte 4 müssen zum Ausziehen derselben nur die Betätigungshebel 11 wiederum von der Anlage ihrer Handgriffe 24 an der Handhabe 16 weg nach außen geschwenkt werden. Dabei wirkt das vordere Ende des Rastarms 12 mit der Anschlagfläche 22 an den Längsträgern 3 zusammn, womit die Karte 4 bei Schwenkung des Betätigungshebels 11 aus den Kontakten bzw. Kontaktfedern der Steckergegenleiste gezogen wird. Daran anschließend kann das weitere Herausziehen der Karte 4 wiederum mittels der Handhabe 16 erfolgen, wobei die Betätigungshebel 11 wieder in der in Fig. 2 dargestellten Stellung sind.

Wie aus den in Fig. 4 und 5 dargestellten Details aus den Fig. 2 und 3 ersichtlich ist, weisen die Betätigungshebel 11 federnd ausgebildete Endhalterungen 25 auf, die hier im wesentlichen aus einem Federarm 26 im Bereich des Lagerauges 27 sowie einem fest mit der Griffleiste in Verbindung stehenden Rastenwinkel 28 bestehen. Zufolge der geknickten Ausführung des Rastenwinkels 28 ergeben sich für die Drehbewegung des Betätigungshebels 11 relativ zu seiner an der Griffleiste 15 fixierten Anlenkung zwei Endstellungen, die oben bereits zu Fig. 2 besprochene Bewegungsenstellung nach Fig. 4 und die oben bereits zu Fig. 3 angesprochene Verriegelungsendstellung nach Fig. 5. Auf diese Weise kann also während der Bewegung der Karte zur Einleitung des Einschiebens mit der Handhabe 16 (Fig. 1 bis 3) allein sicher gearbeitet werden, da dabei gemäß Fig. 4 bzw. 2 der Rastarm 12 sowie überhaupt der gesamte Betätigungshebel 11 in der Bewegungsendstellung gehalten ist, während die Verriegelungsendstellung gemäß Fig. 5 bzw. 3 eine gewisse Transport- bzw. Vibrationssicherung für die Karte 4 ergibt.

Aus den Fig. 1 bis 3 ist leicht ersichtlich, daß der für die Karte 4 senkrecht zu ihrer Bewegungsrichtung zur Verfügung stehende Platz einfach und vorteilhaft durch die Griffleiste 15 selbst vollständig überdeckt werden kann, womit das Innere der Apparatur an der Frontseite abgeschlossen ist und ein Zugriff bzw. unter Umständen auch der Austritt von im Apparat zirkulierter Kühlluft verhindert ist. Auf der Karte können weiters hier nicht dargestellte Frontelemente wie z.B. Stecker, Schalter, Anzeigeelemente od.dgl. angeordnet sein, die durch in der Griffleiste 15 vorgesehene Fenster betätigbar sind. In den Fig. 2 und 3 ist an der Handhabe 16 eine Halterung 29 für einen Bezeichnungsstreifen od.dgl. zu erkennen.

Die Griffleiste 15 sowie auch die Betätigungshebel 11 samt deren Anlenkung an der Griffleiste 15 bestehen hier aus einem Material mit definierter Leitfähigkeit beispielsweise aus leitfähigem Kunststoff, wodurch bei eingeschobener Karte und in die Rasten 13 eingreifenden Betätigungshebeln 11 eine elektrische Verbindung mit den Querträgern 1,2 geschaffen wird. Zweckmäßig ist die Griffleiste 15 mit der Masseleitung der Karte 4 über einen definierten Ableitwiderstand verbunden, womit ein langsamer Potentialausgleich gegen Erde zur Vermeidung der schädlichen Auswirkung von elektrostatischen Aufladungen auf die Bauelemente bzw. Baugruppen auf der Karte 4 möglich ist. Weiters kann die Griffleiste 15 auch auf hier nicht dargestellte Weise zur elektrischen bzw. magnetischen Abschirmung metallisch, z.B. mit Ni, beschichtet sein.

**Patentansprüche**

1. Vorrichtung zum Einschieben bzw. Ausziehen von mit Steckerleisten versehenen Karten oder anderen Einschüben mit elektrischen bzw. elektronischen Bauteilen in bzw. aus die Steckerleisten aufnehmenden apparatefesten Steckergegenleisten, wobei die Karten in Einschiebbzw. Ausziehrichtung in Längsträgern, welche zusammen mit sie tragenden Querträgern apparatefest sind, geführt sind, und wobei im Bereich der äußeren Ecken der Karten in der Kartenebene drehbare, zweiarmige Betätigungshebel an den Karten angelenkt sind, die im Bereich der Zusammenwirkung von Steckerleisten und Steckergegenleisten mit einem Rastarm mit apparatefesten Rasten zusammenwirken, dadurch gekennzeichnet, daß die Betätigungshebel (11) an einer mit der äußeren Stirnkante (14) der Karte (4) verbundenen Griffleiste (15) angelenkt sind und im bewegbaren ausgezogenen Zustand der Karte (4) im wesentlichen innerhalb der seitlichen Kartenkanten (17) liegen.

2. Vorrichtung nach Anspruch 1, dadurch gekennzeichnet, daß die Griffleiste (15) in ihrem Mittelbereich eine Handhabe (16) aufweist, an welcher die Handgriffe (24) der Betätigungshebel (11) im eingeschobenen Zustand anliegen.

3. Vorrichtung nach Anspruch 1 oder 2, dadurch gekennzeichnet, daß die Betätigungshebel (11) über federnd ausgebildete Endhalterungen (25) in einer Bewegungs- und einer Verriegelungsendstellung gehalten sind, wobei die zusammenwirkenden Teile dieser Endhalterungen (25) am Betätigungshebel (11) einerseits und an der Griffleiste (15) anderseits angebracht sind.

4. Vorrichtung nach 1, 2 oder 3, dadurch gekennzeichnet, daß die Griffleiste (15) den für die Karte (4) senkrecht zu ihrer Bewegungsrichtung zur Verfügung stehenden Platz im Eingeschobenen Zustand der Karte (4) im we sentlichen vollständig überdeckt.

5. Vorrichtung nach einem der Ansprüche 1 bis 4, dadurch gekennzeichnet, daß die Griffleiste (15) mit Fenstern oder Öffnungen versehen ist, durch die hindurch auf der Karte angeordnete Frontelemente, z.B. Stecker, Schalter und Anzeigen, betätigbar sind.

6. Vorrichtung nach einem der Ansprüche 1 bis 5, dadurch gekennzeichnet, daß die Griffleiste (15) und die Betätigungshebel (11) aus einem Material mit definierter Leitfähigkeit, z.B. aus leitfähigem Kunststoff, bestehen, wobei die Betätigungshebel (11) durch den Eingriff in die zugehörigen Rasten (13) im eingeschobenen Zustand der Karte (4) eine elektrische Verbindung mit den Querträgern (1,2) schaffen.

7. Vorrichtung nach Anspruch 6, dadurch gekennzeichnet, daß die Griffleiste (15) samt den Betätigungshebeln (11) mit der Masseleitung der Karte (4) über einen definierten Ableitwiderstand elektrisch verbunden sind.

8. Vorrichtung nach Anspruch 6 oder 7, dadurch gekennzeichnet, daß die Griffleiste (15) zur elektrischen und magnetischen Abschirmung metallisch, z.B. mit Ni, beschichtet ist.

0269608

FIG. 2

FIG. 3

0269608

FIG. 1

FIG. 4

FIG. 5